# EUROPEAN PATENT APPLICATION

(11) **EP 4 610 793 A1**
(43) Date of publication of application: **03.09.2025**
(21) Application number: 25160627.3
(22) Date of filing: 27.02.2025
(51) Int. Cl.: G06F 3/041

(54) **DISPLAY DEVICE**

(30) Priority: 01.03.2024 JP 2024031290
(71) Applicant: Magnolia White Corporation, Tokyo (JP)
(72) Inventor: NAKAMURA, Masato, Tokyo 105-0003 (JP); TABATAKE, Hiroshi, Tokyo 105-0003 (JP)
(74) Representative: MERH-IP Matias Erny Reichl Hoffmann Patentanwälte PartG mbB

(57) **Abstract**

According to one embodiment, a display device includes a substrate, a plurality of pixels each of which includes a display element consisting of a lower electrode, an upper electrode and an organic layer, a partition, a touch panel electrode which detects an object which contacts or approaches a display area, and an illumination sensor which is provided on a back side of the substrate and measures an illuminance of light which enters the display device through a front side of the substrate. Each of the pixels includes a transmissive region in which the display element is not provided. The touch panel electrode includes a metal line located above the partition, extending along the partition and having a crank-like shape near a transmissive region included in each of the pixels.

## Description

### FIELD

Embodiments described herein relate generally to a display device.

### BACKGROUND

Recently, display devices to which an organic light emitting diode (OLED) is applied as a display element have been put into practical use. This display element comprises a lower electrode, an organic layer which covers the lower electrode, and an upper electrode which covers the organic layer.

A display device may comprise the function of a touch panel which detects the operation of the user relative to the display area. When an electrode for realizing such a function is provided in the display area, the structure of the display device needs to be designed such that the reduction in the display quality by the electrode is prevented.

Further, a display device may comprise an illumination sensor on the back side and function to adjust the luminance of the display device based on the illuminance measured by the illumination sensor. To realize this function, the display area needs to include a transmissive region which can take in light with a sufficient quantity to allow the illumination sensor to measure the illuminance of light which enters the display device through the front side. Thus, the structure of the display device needs to be further improved.

### BRIEF DESCRIPTION OF THE DRAWINGS

FIG. 1 is a plan view showing a configuration example of a display device according to an embodiment.
FIG. 2 is a diagram showing an example of the layout of subpixels.
FIG. 3 is the schematic cross-sectional view of the display device along the III-III line of FIG. 2.
FIG. 4 is a schematic plan view showing elements for realizing functions related to a touch panel.
FIG. 5 is a schematic cross-sectional view of the display device in a surrounding area.
FIG. 6 is a schematic plan view of pixels and a metal line according to a comparative example.
FIG. 7 is a schematic plan view of the pixels and the metal line according to the comparative example.
FIG. 8 is a schematic plan view of pixels and a metal line according to the embodiment.
FIG. 9 is a schematic plan view of the pixels and the metal line according to the embodiment.
FIG. 10 is a schematic plan view of the pixels and the metal line according to the embodiment.
FIG. 11 is a schematic plan view of the pixels and the metal line according to a modified example.
FIG. 12 is a schematic plan view of the pixels and the metal line according to a modified example.

### DETAILED DESCRIPTION

In general, according to one embodiment, a display device includes a substrate which has a display area displaying an image, a plurality of pixels which are provided in the display area, and each of which includes a display element consisting of a lower electrode, an upper electrode which faces the lower electrode, and an organic layer which is provided between the lower electrode and the upper electrode and emits light based on a potential difference between the lower electrode and the upper electrode, a partition which includes a conductive lower portion and an upper portion protruding from a side surface of the lower portion and surrounds each of the pixels, a touch panel electrode which detects an object which contacts or approaches the display area, and an illumination sensor which is provided on a back side of the substrate and measures an illuminance of light which enters the display device through a front side of the substrate. Each of the pixels includes a transmissive region in which the display element is not provided. The touch panel electrode includes a metal line located above the partition, extending along the partition and having a crank-like shape near the transmissive region included in each of the pixels.

Embodiments will be described with reference to the accompanying drawings.

The disclosure is merely an example, and proper changes in keeping with the spirit of the invention, which are easily conceivable by a person of ordinary skill in the art, come within the scope of the invention as a matter of course. In addition, in some cases, in order to make the description clearer, the widths, thicknesses, shapes, etc., of the respective parts are illustrated schematically in the drawings, rather than as an accurate representation of what is implemented. However, such schematic illustration is merely exemplary, and in no way restricts the interpretation of the invention. In addition, in the specification and drawings, structural elements which function in the same or a similar manner to those described in connection with preceding drawings are denoted by like reference numbers, detailed description thereof being omitted unless necessary.

In the drawings, in order to facilitate understanding, an X-axis, a Y-axis and a Z-axis orthogonal to each other are shown depending on the need. A direction parallel to the X-axis is referred to as a first direction X. A direction parallel to the Y-axis is referred to as a second direction Y. A direction parallel to the Z-axis is referred to as a third direction Z. The third direction Z is a normal direction relative to a plane including the first direction X and the second direction Y. When various elements are viewed parallel to the plane including the first direction X and the second direction Y, the appearance is defined as a plan view.

The display device of an embodiment is an organic electroluminescent display device comprising an organic light emitting diode (OLED) as a display element, and may be mounted on various types of electronic devices such as a television, a personal computer, a vehicle-mounted device, a tablet, a smartphone, a mobile phone and a wearable terminal.

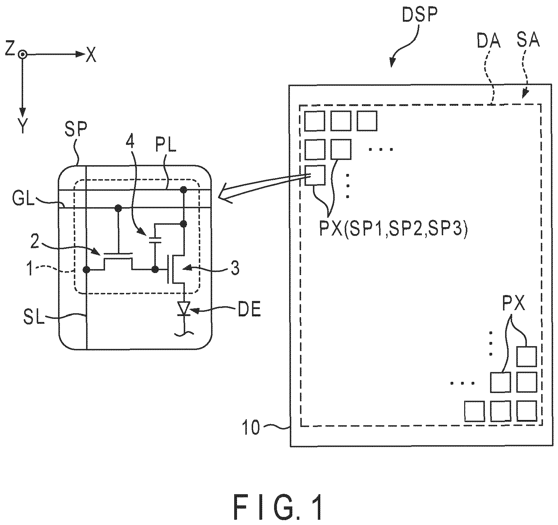

FIG. 1 is a diagram showing a configuration example of a display device DSP according to an embodiment. The display device DSP has a display area DA which displays an image and a surrounding area SA around the display area DA on an insulating substrate 10. The substrate 10 may be glass or a resinous film having flexibility.

In the embodiment, the substrate 10 is rectangular as seen in plan view. It should be noted that the shape of the substrate 10 in plan view is not limited to a rectangle and may be another shape such as a square, a circle or an oval.

The display area DA comprises a plurality of pixels PX arrayed in matrix in a first direction X and a second direction Y. Each pixel PX includes a plurality of subpixels SP. For example, each pixel PX includes a red subpixel (first subpixel) SP1, a green subpixel (second subpixel) SP2 and a blue subpixel (third subpixel) SP3. Each pixel PX may include a subpixel SP which exhibits another color such as white in addition to subpixels SP1, SP2 and SP3 or instead of one of subpixels SP1, SP2 and SP3.

Each subpixel SP comprises a pixel circuit 1 and a display element DE driven by the pixel circuit 1. The pixel circuit 1 comprises a pixel switch 2, a drive transistor 3 and a capacitor 4. Each of the pixel switch 2 and the drive transistor 3 is, for example, a switching element consisting of a thin-film transistor.

The gate electrode of the pixel switch 2 is connected to a scanning line GL. One of the source electrode and drain electrode of the pixel switch 2 is connected to a signal line SL. The other one is connected to the gate electrode of the drive transistor 3 and the capacitor 4. In the drive transistor 3, one of the source electrode and the drain electrode is connected to a power line PL and the capacitor 4, and the other one is connected to the display element DE.

It should be noted that the configuration of the pixel circuit 1 is not limited to the example shown in the figure. For example, the pixel circuit 1 may comprise more thin-film transistors and capacitors.

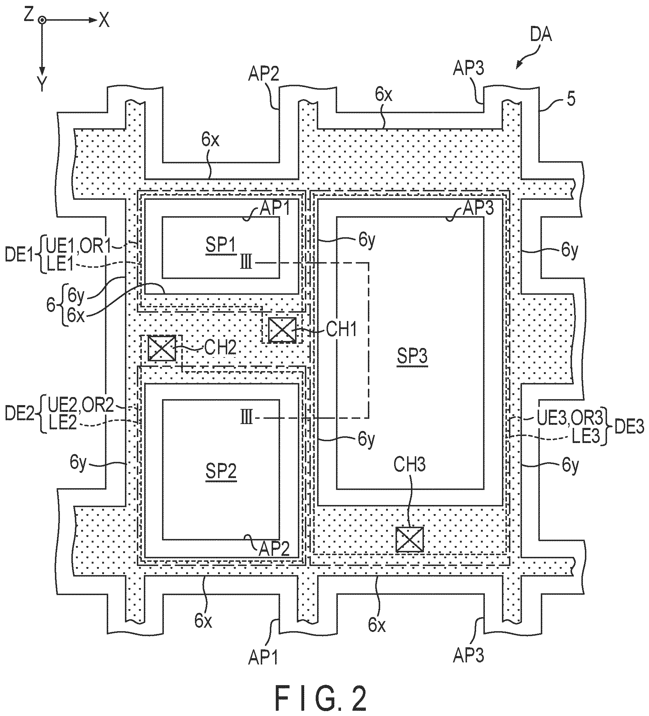

FIG. 2 is a diagram showing an example of the layout of subpixels SP1, SP2 and SP3. In the example of FIG. 2, subpixels SP1 and SP2 are arranged in the second direction Y. Further, each of subpixels SP1 and SP2 is adjacent to subpixel SP3 in the first direction X.

When subpixels SP1, SP2 and SP3 are provided in line with this layout, a column in which subpixels SP1 and SP2 are alternately provided in the second direction Y and a column in which a plurality of subpixels SP3 are repeatedly provided in the second direction Y are formed in the display area DA. These columns are alternately arranged in the first direction X. It should be noted that the layout of subpixels SP1, SP2 and SP3 is not limited to the example of FIG. 2.

A rib 5 and a partition 6 are provided in the display area DA. The rib 5 has pixel apertures AP1, AP2 and AP3 in subpixels SP1, SP2 and SP3, respectively. In the example of FIG. 2, the pixel aperture AP2 is larger than the pixel aperture AP1. The pixel aperture AP3 is larger than the pixel aperture AP2.

The partition 6 is provided in the boundary between adjacent subpixels SP and overlaps the rib 5 as seen in plan view. The partition 6 comprises a plurality of first partitions 6x extending in the first direction X and a plurality of second partitions 6y extending in the second direction Y. The first partitions 6x are provided between the pixel apertures AP1 and AP2 which are adjacent to each other in the second direction Y and between two pixel apertures AP3 which are adjacent to each other in the second direction Y. Each second partition 6y is provided between the pixel apertures AP1 and AP3 which are adjacent to each other in the first direction X and between the pixel apertures AP2 and AP3 which are adjacent to each other in the first direction X.

In the example of FIG. 2, the first partitions 6x and the second partitions 6y are connected to each other. In this configuration, the partition 6 has a grating shape surrounding the pixel apertures AP1, AP2 and AP3 as a whole. In other words, the partition 6 has apertures in subpixels SP1, SP2 and SP3 in a manner similar to that of the rib 5.

Subpixel SP1 comprises a lower electrode LE1, an upper electrode UE1 and an organic layer OR1 overlapping the pixel aperture AP1. Subpixel SP2 comprises a lower electrode LE2, an upper electrode UE2 and an organic layer OR2 overlapping the pixel aperture AP2. Subpixel SP3 comprises a lower electrode LE3, an upper electrode UE3 and an organic layer OR3 overlapping the pixel aperture AP3.

Of the lower electrode LE1, the upper electrode UE1 and the organic layer OR1, the portions which overlap the pixel aperture AP1 constitute the display element DE1 of subpixel SP1. Of the lower electrode LE2, the upper electrode UE2 and the organic layer OR2, the portions which overlap the pixel aperture AP2 constitute the display element DE2 of subpixel SP2. Of the lower electrode LE3, the upper electrode UE3 and the organic layer OR3, the portions which overlap the pixel aperture AP3 constitute the display element DE3 of subpixel SP3. Each of the display elements DE1, DE2 and DE3 may further include a cap layer as described later. The rib 5 and the partition 6 surround each of these display elements DE1, DE2 and DE3.

The lower electrode LE1 is connected to the pixel circuit 1 (see FIG. 1) of subpixel SP1 through a contact hole CH1. The lower electrode LE2 is connected to the pixel circuit 1 of subpixel SP2 through a contact hole CH2. The lower electrode LE3 is connected to the pixel circuit 1 of subpixel SP3 through a contact hole CH3.

In the example of FIG. 2, the contact holes CH1 and CH2 entirely overlap the first partition 6X between the pixel apertures AP1 and AP2 which are adjacent to each other in the second direction Y. The contact hole CH3 entirely overlaps the first partition 6x between two pixel apertures AP3 which are adjacent to each other in the second direction Y. As another example, at least part of the contact hole CH1, CH2 or CH3 may not overlap the first partition 6x.

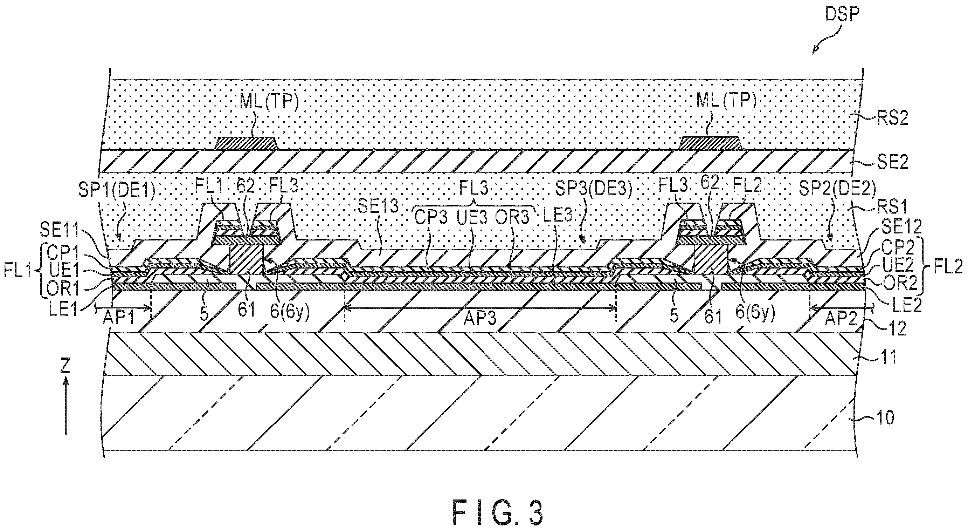

FIG. 3 is the schematic cross-sectional view of the display device DSP along the III-III line of FIG. 2. A circuit layer 11 is provided on the substrate 10 described above. The circuit layer 11 includes various circuits and lines such as the pixel circuits 1, scanning lines GL, signal lines SL and power lines PL shown in FIG. 1.

The circuit layer 11 is covered with an organic insulating layer 12. The organic insulating layer 12 functions as a planarization film which planarizes the irregularities formed by the circuit layer 11. Although not shown in the section of FIG. 3, the contact holes CH1, CH2 and CH3 described above are provided in the organic insulating layer 12.

The lower electrodes LE1, LE2 and LE3 are provided on the organic insulating layer 12. The rib 5 is provided on the organic insulating layer 12 and the lower electrodes LE1, LE2 and LE3. The end portions of the lower electrodes LE1, LE2 and LE3 are covered with the rib 5.

The partition 6 includes a conductive lower portion 61 provided on the rib 5 and an upper portion 62 provided on the lower portion 61. The upper portion 62 has a width greater than that of the lower portion 61. By this configuration, in FIG. 3, the both end portions of the upper portion 62 protrude relative to the side surfaces of the lower portion 61. This shape of the partition 6 is called an overhang shape.

The organic layer OR1 covers the lower electrode LE1 through the pixel aperture AP1. The upper electrode UE1 covers the organic layer OR1 and faces the lower electrode LE1. The organic layer OR2 covers the lower electrode LE2 through the pixel aperture AP2. The upper electrode UE2 covers the organic layer OR2 and faces the lower electrode LE2. The organic layer OR3 covers the lower electrode LE3 through the pixel aperture AP3. The upper electrode UE3 covers the organic layer OR3 and faces the lower electrode LE3.

In the example of FIG. 3, a cap layer CP1 is provided on the upper electrode UE1. A cap layer CP2 is provided on the upper electrode UE2. A cap layer CP3 is provided on the upper electrode UE3. The cap layers CP1, CP2 and CP3 adjust the optical property of the light emitted from the organic layers OR1, OR2 and OR3, respectively.

In the following explanation, a stacked layer body including the organic layer OR1, the upper electrode UE1 and the cap layer CP1 is called a thin film FL1. A stacked layer body including the organic layer OR2, the upper electrode UE2 and the cap layer CP2 is called a thin film FL2. A stacked layer body including the organic layer OR3, the upper electrode UE3 and the cap layer CP3 is called a thin film FL3.

The thin film FL1 is partly located on the upper portion 62. This portion is spaced apart from, of the thin film FL1, the portion located under the partition 6 (in other words, the portion which constitutes the display element DE1). Similarly, the thin film FL2 is partly located on the upper portion 62. This portion is spaced apart from, of the thin film FL2, the portion located under the partition 6 (in other words, the portion which constitutes the display element DE2). Further, the thin film FL3 is partly located on the upper portion 62. This portion is spaced apart from, of the thin film FL3, the portion located under the partition 6 (in other words, the portion which constitutes the display element DE3).

Sealing layers (first sealing layers) SE11, SE12 and SE13 are provided in subpixels SP1, SP2 and SP3, respectively. The sealing layer SE11 continuously covers the thin film FL1 and the partition 6 around subpixel SP1. The sealing layer SE12 continuously covers the thin film FL2 and the partition 6 around subpixel SP2. The sealing layer SE13 continuously covers the thin film FL3 and the partition 6 around subpixel SP3. The sealing layers SE11, SE12 and SE13 cover the pixel PX as a whole. Hereinafter, when there is no need to distinguish the sealing layers SE11, SE12 and SE13 from each other, they may be simply referred to as a sealing layer SE1.

In the example of FIG. 3, the thin film FL1 and sealing layer SE11 located on the partition 6 between subpixels SP1 and SP3 are spaced apart from the thin film FL3 and sealing layer SE13 located on this partition 6. The thin film FL2 and sealing layer SE12 located on the partition 6 between subpixels SP2 and SP3 are spaced apart from the thin film FL3 and sealing layer SE13 located on this partition 6.

The sealing layers SE11, SE12 and SE13 are covered with a resin layer (first resin layer) RS1. The resin layer RS1 is covered with a sealing layer (second sealing layer) SE2. The sealing layer SE2 is covered with a resin layer (second resin layer) RS2. The resin layers RS1 and RS2 and the sealing layer SE2 are continuously provided in at least the entire display area DA and partly extend in the surrounding area SA as well.

A cover member such as a polarizer, a touch panel, a protective film or a cover glass may be further provided above the resin layer RS2. This cover member may be attached to the resin layer RS2 via, for example, an adhesive layer such as an optical clear adhesive (OCA).

In the example of FIG. 3, a metal line ML which constitutes touch panel electrodes TP is provided on the sealing layer SE2. The metal line ML is located above the partition 6 and extends mostly along the partition 6. The metal line ML is covered with the resin layer RS2.

The organic insulating layer 12 is formed of an organic insulating material. Each of the rib 5 and the sealing layers SE11, SE12, SE13 and SE2 is formed of, for example, an inorganic insulating material such as silicon nitride (SiNx), silicon oxide (SiOx) or silicon oxynitride (SiON). Each of the rib 5, the sealing layers SE11, SE12, SE13 and SE2 may be a stacked layer body formed of different types of inorganic insulating materials. Each of the resin layers RS1 and RS2 is formed of, for example, a resinous material (organic insulating material) such as epoxy resin or acrylic resin.

Each of the lower electrodes LE1, LE2 and LE3 has a reflective layer formed of, for example, silver (Ag), and a pair of conductive oxide layers covering the upper and lower surfaces of the reflective layer. Each conductive oxide layer may be formed of, for example, a transparent conductive oxide such as indium tin oxide (ITO), indium zinc oxide (IZO) or indium gallium zinc oxide (IGZO).

Each of the upper electrodes UE1, UE2 and UE3 is formed of, for example, a metal material such as an alloy of magnesium and silver (MgAg). For example, the lower electrodes LE1, LE2 and LE3 correspond to anodes, and the upper electrodes UE1, UE2 and UE3 correspond to cathodes.

For example, each of the organic layers OR1, OR2 and OR3 comprises a multilayer structure consisting of a hole injection layer, a hole transport layer, an electron blocking layer, a light emitting layer, a hole blocking layer, an electron transport layer and an electron injection layer. Each of the organic layers OR1, OR2 and OR3 may comprise a tandem structure including a plurality of light emitting layers.

Each of the cap layers CP1, CP2 and CP3 is formed of, for example, a multilayer body consisting of a plurality of transparent thin films. As the thin films, the multilayer body may include a thin film formed of an inorganic material and a thin film formed of an organic material. These thin films have refractive indices different from each other. The materials of the thin films constituting the multilayer body are different from the materials of the upper electrodes UE1, UE2 and UE3 and are also different from the materials of the sealing layers SE11, SE12 and SE13. It should be noted that the cap layers CP1, CP2 and CP3 may be omitted.

The metal line ML is formed of a metal material. For example, the metal line ML comprises a stacked structure of titanium (Ti), aluminum (Al) and titanium. However, the metal line ML may comprise a stacked structure of other metal materials or may comprise a single-layer structure.

The lower portion 61 of the partition 6 is formed of, for example, aluminum. The lower portion 61 may be formed of an aluminum alloy such as an aluminum-neodymium alloy (AlNd) or may comprise a multilayer structure consisting of an aluminum layer and an aluminum alloy layer. Further, the lower portion 61 may have a thin film formed of a metal material different from aluminum and an aluminum alloy under the aluminum layer or the aluminum alloy layer. This thin film can be formed of, for example, molybdenum (Mo).

For example, the upper portion 62 of the partition 6 comprises a multilayer structure consisting of a thin film formed of a metal material such as titanium and a thin film formed of a conductive oxide such as ITO. The upper portion 62 may comprise a single-layer structure of a metal material such as titanium. The upper portion 62 may comprise a single-layer structure of an inorganic insulating material different from the sealing layers SE11, SE12 and SE13.

Common voltage is applied to the partition 6. This common voltage is applied to each of the upper electrodes UE1, UE2 and UE3 which are in contact with the side surfaces of the lower portions 61. Pixel voltage is applied to the lower electrodes LE1, LE2 and LE3 through the pixel circuits 1 provided in subpixels SP1, SP2 and SP3, respectively.

When a potential difference is formed between the lower electrode LE1 and the upper electrode UE1, the light emitting layer of the organic layer OR1 emits light in a red wavelength range. When a potential difference is formed between the lower electrode LE2 and the upper electrode UE2, the light emitting layer of the organic layer OR2 emits light in a green wavelength range. When a potential difference is formed between the lower electrode LE3 and the upper electrode UE3, the light emitting layer of the organic layer OR3 emits light in a blue wavelength range.

As another example, the light emitting layers of the organic layers OR1, OR2 and OR3 may emit light exhibiting the same color (for example, white). In this case, the display device DSP may comprise color filters which convert the light emitted from the light emitting layers into light exhibiting colors corresponding to subpixels SP1, SP2 and SP3. The display device DSP may comprise a layer including quantum dots which generate light exhibiting colors corresponding to subpixels SP1, SP2 and SP3 by the excitation caused by the light emitted from the light emitting layers.

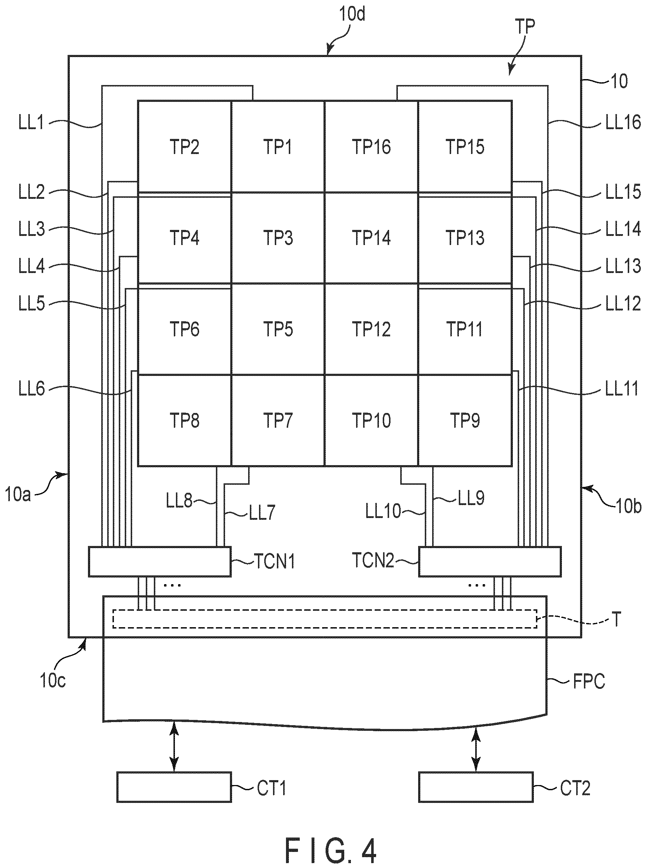

FIG. 4 is a schematic plan view showing elements for realizing functions related to a touch panel. The substrate 10 has end portions 10a, 10b, 10c and 10d. The end portions 10a and 10b extend parallel to the second direction Y. The end portions 10c and 10d extend parallel to the first direction X. In the display area DA located on the substrate 10, a plurality of touch panel electrodes TP are provided. In the example of FIG. 4, 16 (4 rows × 4 columns) touch panel electrodes TP1 to TP16 are arranged in matrix. The touch panel electrodes TP1 to TP8 are located on the left half side of the display area DA. The touch panel electrodes TP9 to TP16 are located on the right half side of the display area DA. It should be noted that the number or layout form of the touch panel electrodes TP is not limited to this example.

Leads LL1 to LL16 are connected to the touch panel electrodes TP1 to TP16, respectively. The leads LL1 to LL8 are electrically connected to a terminal portion T via a connection portion TCN1. The leads LL9 to LL16 are electrically connected to the terminal portion T via a connection portion TCN2. For example, the touch panel electrodes TP1 to TP8, the leads LL1 to LL8 and the connection portion TCN1 and the touch panel electrodes TP9 to TP16, the leads LL9 to LL16 and the connection portion TCN2 have a line-symmetric shape with respect to the center line of the display device DSP in the first direction X.

An end of a flexible printed circuit FPC is connected to the terminal portion T via, for example, a conductive adhesive. The other end of the flexible printed circuit FPC is connected to the substrate of an electronic device on which the display device DSP is mounted. The video signals and power necessary to display images are supplied to the display device DSP through the flexible printed circuit FPC.

The display device DSP further comprises a display controller CT1 which performs control related to image display and a detection controller CT2 which performs control related to touch detection. These controllers CT1 and CT2 consist of, for example, ICs, and are mounted on the flexible printed circuit FPC. The controllers CT1 and CT2 may be mounted on separate flexible printed circuits, and these flexible printed circuits may be connected to the terminal portion T.

This embodiment assumes a case where the touch panel electrodes TP1 to TP16 constitute a capacitive touch panel. For example, when an object such as a finger of the user contacts or approaches the display area DA, the detection controller CT2 specifies the position contacted or approached by the object based on the change generated in the capacitance of the touch panel electrodes TP1 to TP16 at the time of the contact or approach. This system is called self capacitive sensing.

It should be noted that mutual capacitive sensing may be applied as the system for detecting objects. In this case, a drive electrode is provided in the display area DA in addition to the touch panel electrodes TP1 to TP16. When an object contacts or approaches the display area DA, the electric field between the touch panel electrodes TP1 to TP16 and the drive electrode is affected by the object, and thus, the capacitance between the touch panel electrodes TP1 to TP16 and the drive electrode changes. The detection controller CT2 specifies the position contacted or approached by the object based on the change in the capacitance.

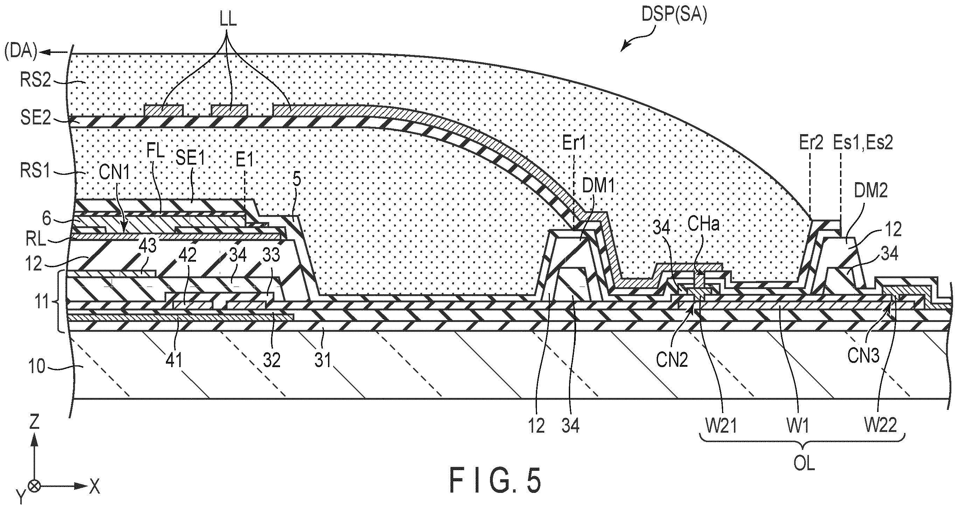

FIG. 5 is a schematic cross-sectional view of the display device DSP in the surrounding area SA.

The circuit layer 11 shown in FIG. 3 has inorganic insulating layers 31, 32 and 33 each of which is formed of an inorganic insulating material, an organic insulating layer 34 formed of an organic insulating material, and metal layers 41, 42 and 43. The inorganic insulating layer 31 covers the upper surface of the substrate 10. The metal layer 41 is provided on the inorganic insulating layer 31. The inorganic insulating layer 32 covers the metal layer 41. The metal layer 42 is provided on the inorganic insulating layer 32. The inorganic insulating layer 33 covers the metal layer 42. The organic insulating layer 34 covers the inorganic insulating layer 33. The metal layer 43 is provided on the organic insulating layer 34 and is covered with the organic insulating layer 12.

Each of the inorganic insulating layers 31, 32 and 33 is formed of, for example, an inorganic material such as silicon nitride or silicon oxide. For example, each of the metal layers 41, 42 and 43 comprises a single-layer structure of a metal material such as molybdenum (Mo), tungsten (W), a molybdenum tungsten alloy (MoW), aluminum (Al) or copper (Cu), or a multilayer structure of these metal materials. The metal layer 41 forms the scanning lines GL shown in, for example, FIG. 1. The metal layer 42 forms the signal lines SL shown in, for example, FIG. 1.

Both dam portion DM1 and dam portion DM2 protrude to the upper side of the substrate 10. In the example of FIG. 5, the dam portions DM1 and DM2 consist of the organic insulating layers 12 and 34. In other words, in the embodiment, the dam portions DM1 and DM2 are formed of the same materials as the organic insulating layers 34 and 12 in the same layers as the organic insulating layers 34 and 12.

In the surrounding area SA, a conductive relay layer RL which connects the partition 6 and a power supply line (not shown) is further provided, and moreover, the rib 5 is provided. For example, the relay layer RL is formed of the same material by the same process as the lower electrodes LE1, LE2 and LE3 described above. The relay layer RL is provided on the organic insulating layer 12 and is covered with the rib 5.

The partition 6 is provided on the rib 5. The partition 6 is in contact with the relay layer RL in a contact portion (first contact portion) CN1 overlapping the organic insulating layer 12 as seen in plan view. The rib 5 is open in the contact portion CN1.

The partition 6 is covered with a thin film FL. The thin film FL is covered with a sealing layer SE1. The sealing layer SE1 continuously covers the thin film FL, the rib 5, the organic insulating layers 12 and 34 and the dam portions DM1 and DM2. The end portion Es1 of the sealing layer SE1 is located above the dam portion DM2.

As shown in FIG. 5, the thin film FL is divided near the end portion E1 of the partition 6. The sealing layer SE1 continuously covers the divided thin film FL1. In other words, the end portion E2 of the thin film FL is covered with the sealing layer SE1. As the thin film FL is divided in this manner, the path of moisture intrusion through the thin film FL can be blocked.

The resin layer RS1 and sealing layer SE2 shown in FIG. 3 are provided above the sealing layer SE1. The resin layer RS1 covers the sealing layer SE1. When the display device DSP is manufactured, the dam portion DM1 functions to dam up the resin layer RS1 before it is cured.

In the example of FIG. 5, the end portion Er1 of the resin layer RS1 is located above the dam portion DM1. However, the position of the end portion Er1 is not limited to this example.

The sealing layer SE2 covers the end portion Er1 of the resin layer RS1. The sealing layer SE2 is in contact with the sealing layer SE1 in an area located on an external side (the right side in the figure) relative to the end portion Er1. In the example of FIG. 5, the end portion Es2 of the sealing layer SE2 is located above the dam portion DM2 in a manner similar to that of the end portion Es1 of the sealing layer SE1. The resin layer RS1 is surrounded by the sealing layers SE1 and SE2. By this configuration, the moisture intrusion into the resin layer RS1 is prevented.

A lead LL is provided on the sealing layer SE2. An output line OL electrically connected to the lead LL is provided between the dam portions DM1 and DM2. The output line OL has a first line W1 formed by the metal layer 42, and second lines W21 and W22 formed by the metal layer 43. In the example of FIG. 5, the first line W1 and the second line W21 are in contact with each other in a contact portion CN2 located between the dam portions DM1 and DM2. The first line W1 and the second line W22 are in contact with each other in a contact portion CN3 located on an external side relative to the dam portion DM2. The second line W22 is covered with the organic insulating layer 12. Although not shown in this section, the second line W22 is partly exposed from the organic insulating layer 12 on an external side relative to the dam portion DM2, and forms the connection portion TCN described above.

A contact hole CHa penetrates the organic insulating layer 34 and the sealing layers SE1 and SE2. The output line OL and the lead LL are connected to each other via the contact hole CHa.

The resin layer RS2 covers the sealing layer SE2 and the lead LL. When the display device DSP is manufactured, the dam portion DM2 functions to dam up the resin layer RS2 before it is cured. In the embodiment, the end portion Er2 of the resin layer RS2 is located between the end portion Er1 of the resin layer RS1 and the end portions Es1 and Es2 of the sealing layers SE1 and SE2. It should be noted that the position of the end portion Er2 is not limited to the example of FIG. 5.

On the back side (the substrate 10 side) of the display device DSP, an illumination sensor may be provided. The illumination sensor is provided to measure the illuminance of light which enters the display device DSP through the front side of the display device DSP (in other words, external light), and measures the illuminance of light which passes through a transmissive region which does not include any element which blocks light in each pixel PX. By providing the illumination sensor on the back side of the display device DSP in this manner, it is possible to mount the function of automatically adjusting the luminance of the display device DSP based on the illuminance measured by the illumination sensor. For example, the luminance of display device DSP may be set so as to be high in a bright environment, and the luminance of the display device DSP may be set so as to be low in a dark environment.

To mount this function, it is necessary to assure, in the display area DA, a transmissive region which can take in light with a sufficient quantity to allow the illumination sensor provided on the back side of the display device DSP to measure the illuminance of light which enters the display device DSP through the front side of the display device DSP. In particular, in a display device comprising the function of a touch panel like the display device DSP described above, in addition to the elements constituting each pixel PX, the metal line ML constituting the touch panel electrodes TP is provided in the display area DA. Therefore, the structure of the display device needs to be designed to assure the transmissive region described above.

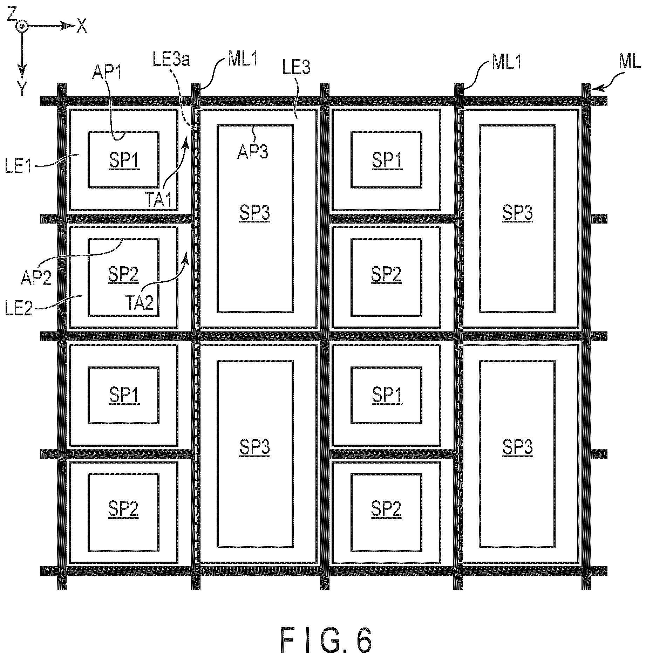

FIG. 6 is a schematic plan view of pixels PX and a metal line ML according to a comparative example. Each pixel PX of the comparative example includes subpixels SP1, SP2 and SP3 arranged in line with the same layout as FIG. 2. It should be noted that FIG. 6 shows, regarding subpixels SP1, SP2 and SP3, of the elements constituting subpixels SP1, SP2 and SP3, only lower electrodes LE and pixel apertures AP (light emitting portions).

Each pixel PX has a transmissive region between subpixels SP1, SP2 and SP3 included in the pixel PX. In other words, no light-shielding element is provided between the lower electrode LE1 constituting subpixel SP1 included in each pixel PX, the lower electrode LE2 constituting subpixel SP2 and the lower electrode LE3 constituting subpixel SP3.

The metal line ML which constitutes touch panel electrodes TP extend along a partition 6 and has a grating shape as a whole. Specifically, the metal line ML is formed by adjusting the position such that the metal line ML surrounds each of subpixels SP1, SP2 and SP3.

It should be noted that, in the metal line ML, each metal line ML1 provided between subpixels SP1 and SP2 and subpixel SP3 in each pixel PX is formed by adjusting the position such that the metal line ML1 overlaps the end portion LE3a of the lower electrode LE3 constituting subpixel SP3 as seen in plan view.

By this configuration, a transmissive region TA1 which does not include any element which blocks light can be provided between the metal line ML1 and the end portion LE1a of the lower electrode LE1 constituting subpixel SP1. Similarly, a transmissive region TA2 which does not include any element which blocks light can be provided between the metal line ML1 and the end portion LE2a of the lower electrode LE2 constituting subpixel SP2.

When two transmissive regions TA1 and TA2 are provided for each pixel PX, the illumination sensor provided on the back side of the display device DSP can obtain light with a sufficient quantity to measure the illuminance of light which enters the display device DSP through the front side of the display device DSP via the transmissive regions TA1 and TA2.

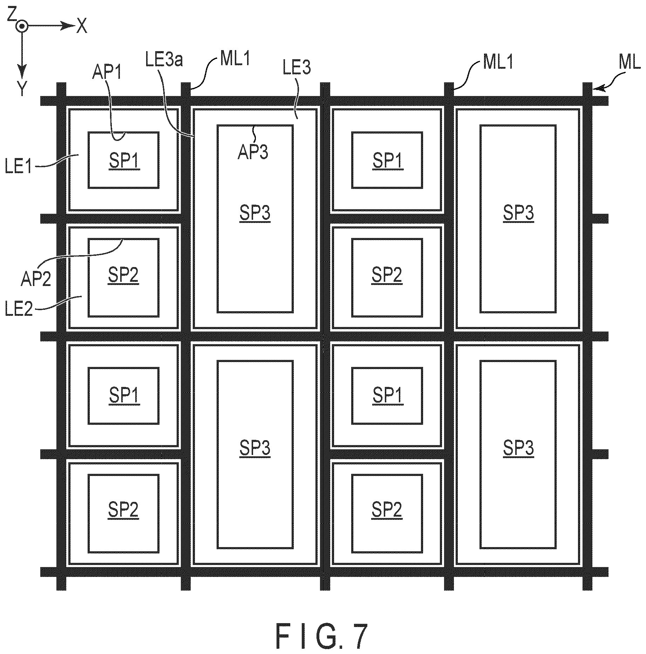

However, in the process of forming the metal line ML which constitutes the touch panel electrodes TP, a misalignment may occur, and the position of the metal line ML may be out of alignment. As a result, when, as shown in, for example, FIG. 7, the metal line ML1 described above deviates to the left side from the desired position shown in FIG. 6, there is a possibility that the metal line ML1 covers the transmissive regions TA1 and TA2 described above. In this configuration, the illumination sensor provided on the back side of the display device DSP cannot take in light with a sufficient quantity to measure the illuminance of light which enters the display device DSP through the front side of the display device DSP. Thus, the illuminance of the light cannot be measured.

To solve this problem, in the embodiment, this specification explains the layout of the metal line ML for assuring a transmissive region which can take in light with a sufficient quantity to allow the illumination sensor provided on the back side of the display device DSP to measure the illuminance of light which enters the display device DSP through the front side of the display device DSP even if a misalignment occurs in the process of forming the metal line ML and the position of the metal line ML is out of alignment.

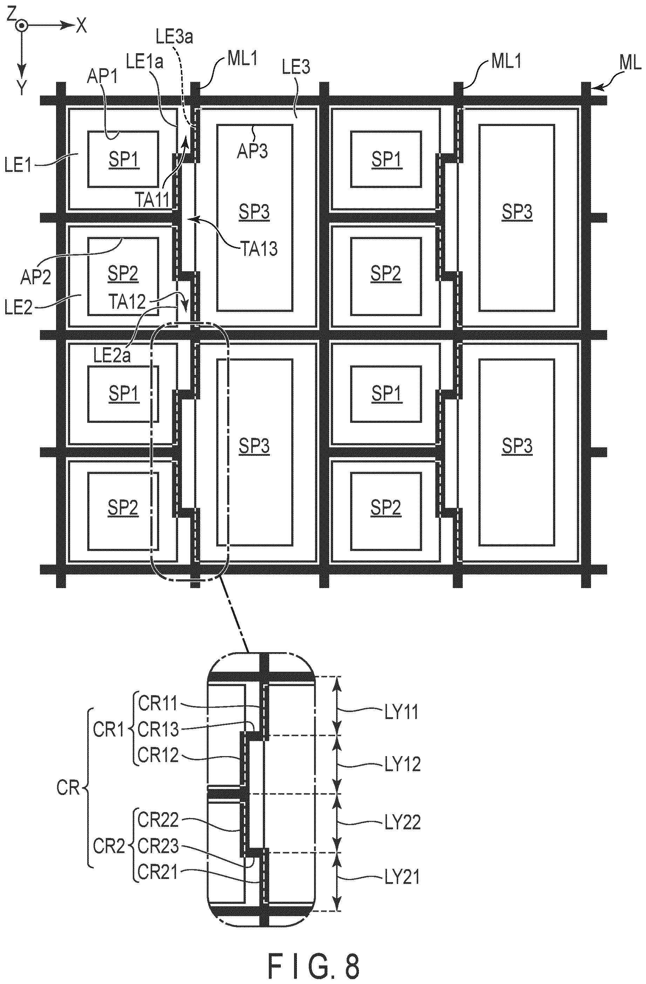

FIG. 8 is a schematic plan view of pixels PX and the metal line ML according to the embodiment. Each pixel PX of the embodiment includes subpixels SP1, SP2 and SP3 arranged in line with the same layout as FIG. 2. It should be noted that FIG. 8 shows, regarding subpixels SP1, SP2 and SP3, of the elements constituting subpixels SP1, SP2 and SP3, only the lower electrodes LE and the pixel apertures AP. In the following description, this specification explains portions which are different from those of the comparative example shown in FIG. 6 and omits explanations of portions which are similar to those of the comparative example shown in FIG. 6.

In the metal line ML which constitutes the touch panel electrodes TP, each metal line ML1 provided between subpixels SP1 and SP2 and subpixel SP3 in a corresponding pixel PX is formed into a crank-like shape including two crank portions CR1 and CR2. The crank portion (first crank portion) CR1 is formed between subpixels SP1 and SP3. The crank portion (second crank portion) CR2 is formed between subpixels SP2 and SP3.

The crank portion CR1 has a first portion CR11 which overlaps the end portion LE3a of the lower electrode LE3 constituting subpixel SP3 and extends in the second direction Y, a second portion CR12 which overlaps the end portion LE1a of the lower electrode LE1 constituting subpixel SP1 and extends in the second direction Y, and a third portion CR13 which connects the end portion of the first portion CR11 and the end portion of the second portion CR12 and extends in the first direction X.

Similarly, the crank portion CR2 has a first portion (fourth portion) CR21 which overlaps the end portion LE3a of the lower electrode LE3 constituting subpixel SP3 and extends in the second direction Y, a second portion (fifth portion) CR22 which overlaps the end portion LE2a of the lower electrode LE2 constituting subpixel SP2 and extends in the second direction Y, and a third portion (sixth portion) CR23 which connects the end portion of the first portion CR21 and the end portion of the second portion CR22 and extends in the first direction X.

It should be noted that the first portion CR11 of the crank portion CR1 does not necessarily overlap the end portion LE3a. For example, the first portion CR11 may be formed on the pixel aperture AP3 side relative to the end portion LE3a of the lower electrode LE3 which constitutes subpixel SP3. However, the first portion CR11 should be preferably formed at a position where it does not overlap the pixel aperture AP3 even if a misalignment occurs in the process of forming the metal line ML. The second portion CR12 of the crank portion CR1 does not necessarily overlap the end portion LE1a. For example, the second portion CR12 may be formed on the pixel aperture AP1 side relative to the end portion LE1a of the lower electrode LE1 which constitutes subpixel SP1. However, the second portion CR12 should be preferably formed at a position where it does not overlap the pixel aperture AP1 even if a misalignment occurs in the process of forming the metal line ML.

Similarly, the first portion CR21 of the crank portion CR2 does not necessarily overlap the end portion LE3a. For example, the first portion CR21 may be formed on the pixel aperture AP3 side relative to the end portion LE3a of the lower electrode LE3 which constitutes subpixel SP3. However, the first portion CR21 should be preferably formed at a position where it does not overlap the pixel aperture AP3 even if a misalignment occurs in the process of forming the metal line ML. The second portion CR22 of the crank portion CR2 does not necessarily overlap the end portion LE2a. For example, the second portion CR22 may be formed on the pixel aperture AP2 side relative to the end portion LE2a of the lower electrode LE2 which constitutes subpixel SP2. However, the second portion CR22 should be preferably formed at a position where it does not overlap the pixel aperture AP2 even if a misalignment occurs in the process of forming the metal line ML.

Thus, since the crank portions CR1 and CR2 are formed at positions where they do not overlap the pixel apertures (light emitting portions) AP even if a misalignment occurs in the process of forming the metal line M, the reduction in the aperture ratio (the reduction in the area of the light emitting region) can be prevented.

As described above, since each metal line ML1 is formed into a crank-like shape including two crank portions CR1 and CR2, a transmissive region TA11 which does not include any element which blocks light can be provided between the first portion CR11 of the crank portion CR1 and the end portion LE1a of the lower electrode LE1 which constitutes subpixel SP1. Further, a transmissive region TA12 which does not include any element which blocks light can be provided between the first portion CR21 of the crank portion CR2 and the end portion LE2a of the lower electrode LE2 which constitutes subpixel SP2. Moreover, a transmissive region TA13 which does not include any element which blocks light can be provided between the second portions CR12 and CR22 of the crank portions CR1 and CR2 and the end portion LE3a of the lower electrode LE3 which constitutes subpixel SP3.

It should be noted that length LY11 of the first portion CR11 of the crank portion CR1, length LY12 of the second portion CR12 of the crank portion CR1, the length LY21 of the first portion CR21 of the crank portion CR2 and length LY22 of the second portion CR22 of the crank portion CR2 should be preferably equal to each other.

This configuration allows the sum of the areas of the transmissive regions TA11 and TA12 to be equal to the area of the transmissive region TA13. Therefore, as described in detail later, even if the metal line ML1 deviates to either side in the lateral direction by a misalignment, half of the sum of the areas of the transmissive regions TA11, TA12 and TA13 can function as a transmissive region, thereby assuring a transmissive region which can take in light with a sufficient quantity to measure the illuminance in the illumination sensor provided on the back side of the display device DSP.

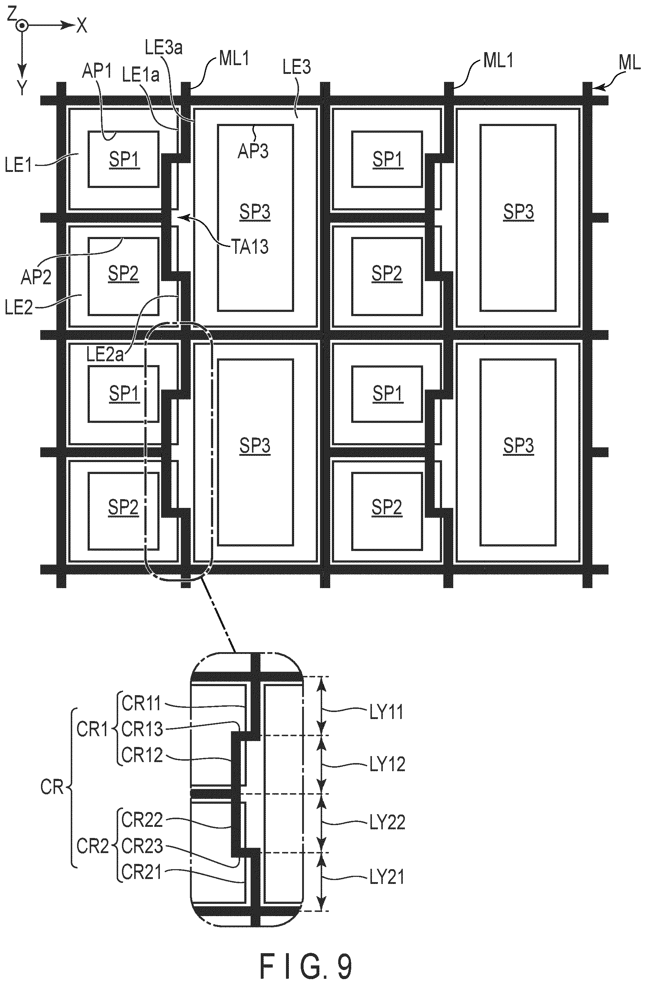

For example, as shown in FIG. 9, when each metal line ML1 deviates to the left side of the figure by a misalignment, the transmissive region TA11 is covered with the first portion CR11 of the crank portion CR1 included in the metal line ML1, and the transmissive region TA12 is covered with the first portion CR21 of the crank portion CR2 included in the metal line ML1. However, the transmissive region TA13 is not covered with the metal line ML1. Thus, it is possible to assure a transmissive region which can take in light with a sufficient quantity to measure the illuminance in the illumination sensor provided on the back side of the display device DSP.

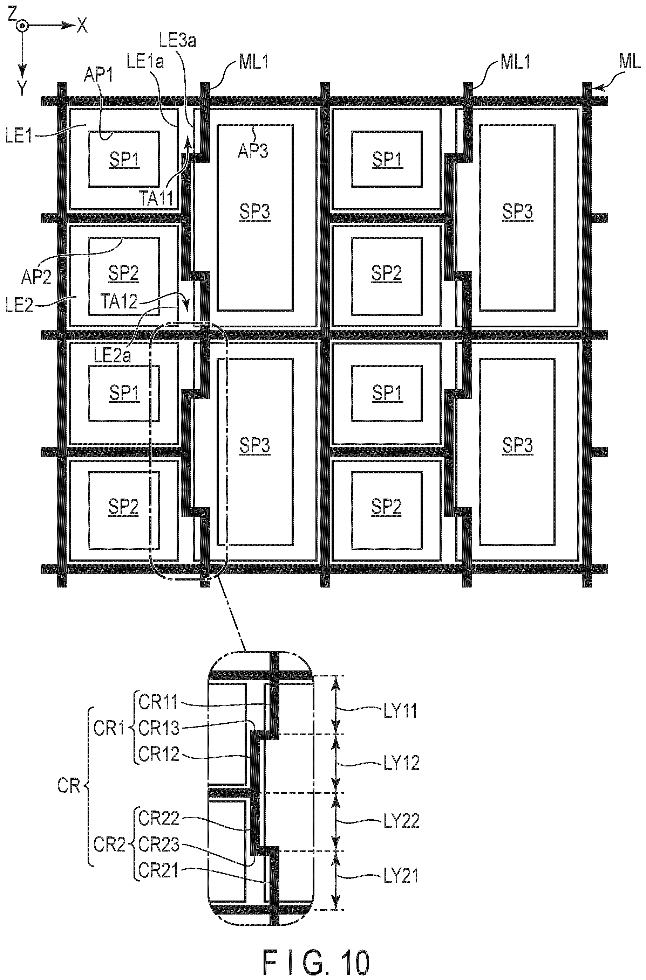

Further, as shown in FIG. 10, when each metal line ML1 deviates to the right side of the figure by a misalignment, the transmissive region TA13 is covered with the second portion CR12 of the crank portion CR1 included in the metal line ML1 and the second portion CR22 of the crank portion CR2 included in the metal line ML1. However, the transmissive region TA11 or TA12 is not covered with the metal line ML1. Thus, it is possible to assure a transmissive region which can take in light with a sufficient quantity to measure the illuminance in the illumination sensor provided on the back side of the display device DSP.

It should be noted that, in FIG. 8, this specification explains a case where, of the metal line ML which constitutes the touch panel electrodes TP, only the metal line ML1 provided between subpixels SP1 and SP2 and subpixel SP3 included in each pixel PX is formed into a crank-like shape. However, of the metal line ML which constitutes the touch panel electrodes TP, the specific line to be formed into a crank-shape is determined based on the position of the transmissive region included in each pixel PX. The metal line ML provided near the transmissive region included in each pixel PX is formed into a crank-like shape.

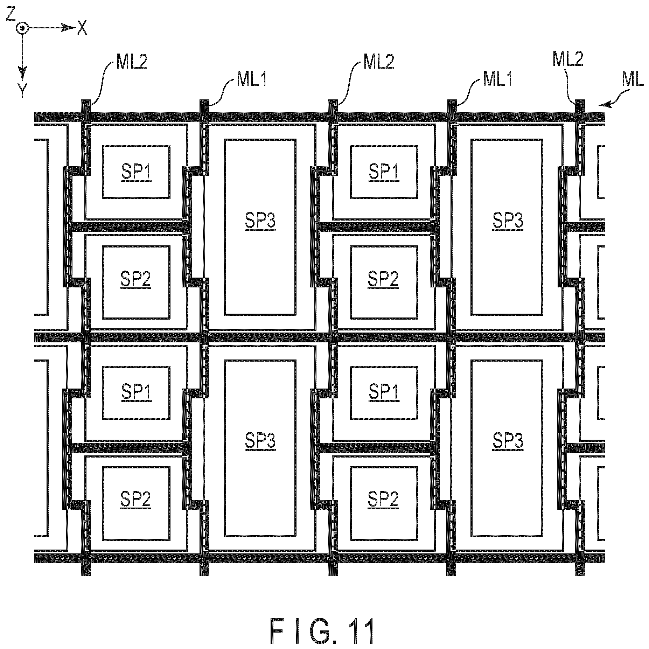

Therefore, for example, as shown in FIG. 11, when a transmissive region is present between subpixels SP1 and SP2 and subpixel SP3 in each pixel PX, and further, a transmissive region is present between subpixels SP1 and SP2 in the pixel PX and subpixel SP3 included in the adjacent pixel PX in the first direction X, a metal line ML2 provided between subpixels SP1 and SP2 included in in each pixel PX and subpixel SP3 included in the adjacent pixel PX in the first direction X may be formed into a crank-like shape in addition to each metal line ML1 described above.

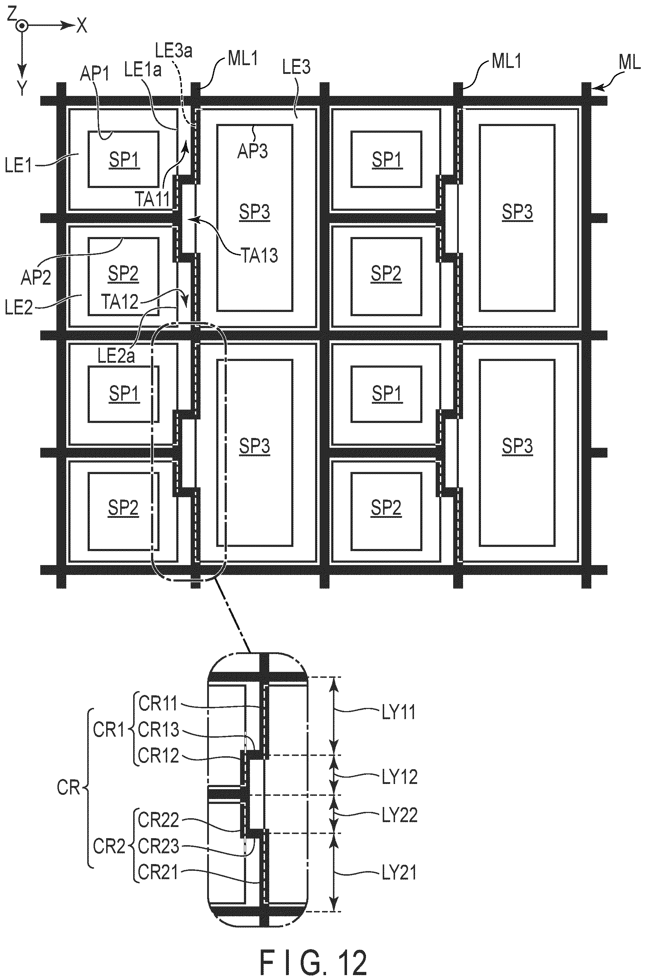

In this embodiment, this specification assumes a case where the area of the transmissive region which can take in light with a sufficient quantity to measure the illuminance in the illumination sensor provided on the back side of the display device DSP is half the sum of the areas of the transmissive regions TA11, TA12 and TA13. However, the area of the transmissive region which can take in light with a sufficient quantity to measure the illuminance in the illumination sensor provided on the back side of the display device DSP is determined based on the performance of the illumination sensor. For example, when the area of the transmissive region which can take in light with a sufficient quantity to measure the illuminance in the illumination sensor provided on the back side of the display device DSP is one third of the sum of the areas of the transmissive regions TA11, TA12 and TA13, the layout of the metal line ML may be that shown in FIG. 12.

In the example of FIG. 12, length LY11 of the first portion CR11 of the crank portion CR1 included in each metal line ML1, length LY21 of the first portion CR21 of the crank portion CR2 included in the metal line ML1 and the sum of length LY12 of the second portion CR12 of the crank portion CR1 included in the metal line ML1 and length LY22 of the second portion CR22 of the crank portion CR2 included in the metal line ML1 are equal to each other. Thus, the areas of the transmissive regions TA11, TA12 and TA13 are equal to each other.

In this case, even if each metal line ML1 deviates to the left side of the figure by a misalignment, one third of the sum of the areas of the transmissive regions TA11, TA12 and TA13 can function as a transmissive region (specifically, the transmissive region TA13 can function as a transmissive region). Even if each metal line ML1 deviates to the right side of the figure by a misalignment, two thirds of the sum of the areas of the transmissive regions TA11, TA12 and TA13 can function as a transmissive region (specifically, the transmissive regions TA11 and TA12 can function as a transmissive region). In this manner, it is possible to assure a transmissive region which can take in light with a sufficient quantity to measure the illuminance in the illumination sensor provided on the back side of the display device DSP.

This embodiment assumes a case where the transmissive region included in each pixel PX does not include any element which blocks light. However, an element which blocks light such as the scanning line GL which extends in the first direction X may be provided in the transmissive region in some cases. In these cases, length LY11 of the first portion CR11 of the crank portion CR1 included in each metal line ML1, length LY12 of the second portion CR12 of the crank portion CR1, length LY21 of the first portion CR21 of the crank portion CR2 and length LY22 of the second portion CR22 of the crank portion CR2 should be preferably determined (in other words, the areas of the transmissive regions TA11, TA12 and TA13 should be preferably determined) in consideration of the area where light is blocked by the scanning line GL etc.

The embodiment described above can provide a display device which has the function of a touch panel, comprises an illumination sensor on the back side and can take in light with a sufficient quantity to allow the illumination sensor to measure the illuminance of light which enters the display device through the front side.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A display device (DSP) **characterized by** comprising:
a substrate (10) which has a display area (DA) displaying an image;
a plurality of pixels (PX) which are provided in the display area (DA), and each of which includes a display element (DE1, DE2, DE3) consisting of:
a lower electrode (LE1, LE2, LE3);
an upper electrode (UE1, UE2, UE3) which faces the lower electrode (LE1, LE2, LE3); and
an organic layer (OR1, OR2, OR3) which is provided between the lower electrode (LE1, LE2, LE3) and the upper electrode (UE1, UE2, UE3) and emits light based on a potential difference between the lower electrode (LE1, LE2, LE3) and the upper electrode (UE1, UE2, UE3);
a partition (6) which includes a conductive lower portion (61) and an upper portion (62) protruding from a side surface of the lower portion (61) and surrounds each of the pixels (PX);
a touch panel electrode (TP) which detects an object which contacts or approaches the display area (DA); and
an illumination sensor which is provided on a back side of the substrate (10) and measures an illuminance of light which enters the display device (DSP) through a front side of the substrate (10), **characterized in that**
each of the pixels (PX) includes a transmissive region (TA11, TA12, TA13) in which the display element (DE1, DE2, DE3) is not provided, and
the touch panel electrode (TP) includes a metal line (ML, ML1) located above the partition (6), extending along the partition (6) and having a crank-like shape (CR) near the transmissive region (TA11, TA12, TA13) included in each of the pixels (PX).

2. The display device (DSP) of claim 1, **characterized in that**
each of the pixels (PX) includes a first subpixel (SP1), a second subpixel (SP2) and a third subpixel (SP3),
each of the first subpixel (SP1) and the second subpixel (SP2) is adjacent to the third subpixel (SP3) in a first direction (X),
the first subpixel (SP1) and the second subpixel (SP2) are arranged in a second direction (Y) intersecting with the first direction (X), and
the transmissive region (TA11, TA12, TA13) is located between the first and second subpixels (SP1,SP2) and the third subpixel (SP3).

3. The display device (DSP) of claim 2, **characterized in that**
the metal line (ML, ML1) has the crank-like shape (CR) consisting of a first crank portion (CR1) and a second crank portion (CR2) near the transmissive region (TA11, TA12, TA13),
the first crank portion (CR1) includes a first portion (CR11) extending along an end portion (LE3a) of the lower electrode (LE3) constituting the third subpixel (SP3) in the second direction (Y), a second portion (CR12) extending along an end portion (LE1a) of the lower electrode (LE1) constituting the first subpixel (SP1) in the second direction (Y), and a third portion (CR13) connecting an end portion of the first portion (CR11) and an end portion of the second portion (CR12) and extending in the first direction (X),
the second crank portion (CR2) includes a fourth portion (CR21) extending along the end portion (LE3a) of the lower electrode (LE3) constituting the third subpixel (SP3) in the second direction (Y), a fifth portion (CR22) extending along an end portion (LE2a) of the lower electrode (LE2) constituting the second subpixel (SP2) in the second direction (Y), and a sixth portion (CR23) connecting an end portion of the fourth portion (CR21) and an end portion of the fifth portion (CR22) and extending in the first direction (X),
the first portion (CR11) and the fourth portion (CR21) are spaced apart from each other, and
the second portion (CR12) is connected to the fifth portion (CR22).

4. The display device (DSP) of claim 3, **characterized in that**
a first region (TA11) located between the first portion (CR11) and the end portion (LE1a) of the lower electrode (LE1) constituting the first subpixel (SP1) in the second direction (Y), a second region (TA12) located between the fourth portion (CR21) and the end portion (LE2a) of the lower electrode (LE2) constituting the second subpixel (SP2) in the second direction (Y) and a third region (TA13) located between the second and fifth portions (CR12, CR22) and the end portion (LE3a) of the lower electrode (LE3) constituting the third subpixel (SP3) in the second direction (Y) overlap the transmissive region (TA11, TA12, TA13) as seen in plan view, and do not include any element (DE1, DE2, DE3) which blocks light.

5. The display device (DSP) of claim 4, **characterized in that**
a length (LY11) of the first portion (CR11), a length (LY12) of the second portion (CR12), a length (LY21) of the fourth portion (CR21) and a length (LY22) of the fifth portion (CR22) are equal to each other, and
a sum of areas of the first region (TA11) and the second region (TA12) is equal to an area of the third region (TA13).

6. The display device (DSP) of claim 4, **characterized in that**
a length (LY11) of the first portion (CR11), a length (LY21) of the fourth portion (CR21) and a sum of lengths (LY12, LY22) of the second and fifth portions (CR12, CR22) are equal to each other, and
an area of the first region (TA11), an area of the second region (TA12) and an area of the third region (TA13) are equal to each other.

7. The display device (DSP) of at least one of the previous claims, **characterized in that**
the metal line (ML, ML1) is provided so as not to overlap a light emitting portion of each pixel (PX) as seen in plan view.

8. The display device (DSP) of at least one of the previous claims, **characterized by** further comprising:
a plurality of first sealing layers (SE1) which cover the respective pixels (PX);
a first resin layer (RS1) which covers the first sealing layers (SE1);
a second sealing layer (SE2) which covers the first resin layer (RS1); and
a second resin layer (RS2) which covers the second sealing layer (SE2), wherein
the metal line (ML, ML1) is provided on the second sealing layer (SE2) and is covered with the second resin layer (RS2).

9. The display device (DSP) of at least one of the previous claims, **characterized by** further comprising:
a terminal portion (T) provided in a surrounding area (SA) located around the display area (DA); and
a lead (LL1 to LL16) which is provided in the surrounding area (SA) and electrically connects the terminal portion (T) and the touch panel electrode (TP).
